(19) Europäisches Patentamt
European Patent Office
Office européen des brevets

(11) **EP 4 674 612 A1**

(12) **EUROPEAN PATENT APPLICATION**

(43) Date of publication:
**07.01.2026 Bulletin 2026/02**

(21) Application number: **25185811.4**

(22) Date of filing: **27.06.2025**

(51) International Patent Classification (IPC):
***B32B 5/02*** *(2006.01)* ***B32B 5/26*** *(2006.01)*
***B32B 7/12*** *(2006.01)* ***B32B 27/12*** *(2006.01)*
***B32B 27/28*** *(2006.01)* ***B32B 27/30*** *(2006.01)*
***B32B 27/32*** *(2006.01)* ***B32B 27/36*** *(2006.01)*
***B32B 27/38*** *(2006.01)* ***B32B 27/42*** *(2006.01)*

(52) Cooperative Patent Classification (CPC):
**B32B 5/022; B32B 5/266; B32B 7/12; B32B 27/12; B32B 27/281; B32B 27/283; B32B 27/30; B32B 27/308; B32B 27/32; B32B 27/36; B32B 27/38; B32B 27/42;** B32B 2260/023; B32B 2260/046; B32B 2262/106; (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **01.07.2024 JP 2024106298**

(71) Applicant: **SHIN-ETSU CHEMICAL CO., LTD.**
**Tokyo 1000005 (JP)**

(72) Inventor: **TANAKA, Ryo**
**Annaka-shi, 3790224 (JP)**

(74) Representative: **Mewburn Ellis LLP**
**Aurora Building**
**Counterslip**
**Bristol BS1 6BX (GB)**

(54) **ELECTROMAGNETIC WAVE-SHIELDING SHEET**

(57) An electromagnetic-shielding sheet (1a, 1b or 1c) is provided comprising a multilayer film including at least two layers (2) of carbon nanotube nonwoven fabric, a pressure-sensitive adhesive layer (5), and a release film (6). The sheet exerts the electromagnetic-shielding effect while minimizing the thickness of carbon nanotube nonwoven fabric, is easy to handle, and is used to cover electronic parts and connections within electronic equipment.

**FIG.1A**

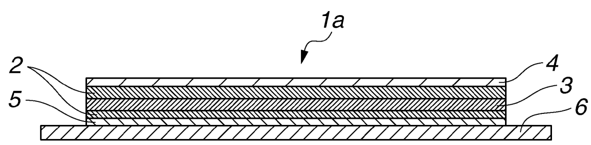


**FIG.1B**

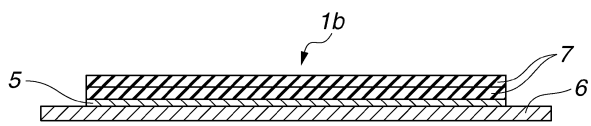


**FIG.1C**

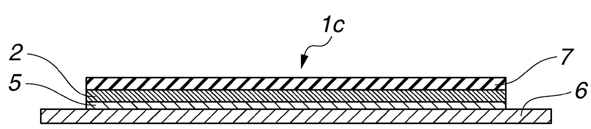


EP 4 674 612 A1

(52) Cooperative Patent Classification (CPC): (Cont.)
B32B 2307/202; B32B 2307/212; B32B 2307/7376;
B32B 2307/748; B32B 2457/00

## Description

### TECHNICAL FIELD

This invention relates to an electromagnetic wave-shielding sheet adapted to cover electronic parts or wirings within electronic instruments for shielding them from electromagnetic waves.

### BACKGROUND

Current efforts are made to implement high-speed communications like 5G or 6G utilizing electromagnetic waves (EM) in the extremely high frequency (EHF) or terahertz band as a commercial application. Wireless equipment utilizing EM for communications are increasing. There are increasing EM available in the space. In such an environment, an electronic equipment will malfunction by the interference of surrounding electromagnetic waves and its own EM emission can cause leakage of information. Also for promoting automatic driving of vehicles, it is necessary to correctly carry out transmission and reception of EM from low to high frequency.

To avoid the EM interference, the EM-shielding measure is regarded as an important technical problem. Under the circumstances, there is the demand for EM-shielding material having EM-shielding performance in the microwave, EHF and terahertz bands. As the use of EM is sophisticated, there is an increasing need for providing the EM-shielding material with new functions toward thin film, light weight and large area.

As the EM-shielding material, a number of EM-shielding techniques using not only metal materials, but also carbon black, graphene, carbon nanotubes, and electroconductive polymers have been proposed. Among these, carbon nanotubes (CNTs) are regarded as the promising EM-shielding material.

As the EM-shielding material using CNTs, Patent Document 1 discloses a paste material having CNTs dispersed in a resin. Patent Document 2 describes an aqueous coating material having CNTs dispersed in aqueous solution. However, they are awkward to handle. The CNTs used therein are of fine fibril form, have a large specific surface area, and cannot be dispersed in a large amount. The resulting materials have an insufficient electro-conductivity below the practically acceptable level.

Patent Document 3 discloses an EM-shielding material in which the conductivity of a sheet of CNTs is increased by adding a protonation agent such as hydronium ion or hydrochloric acid and further adding a ferromagnetic ingredient such as iron or cobalt. However, its conductivity is low and its return loss is small as compared with metal foils such as aluminum and copper. For acquiring a shielding performance equivalent to metals, it is necessary to increase the thickness of the sheet to increase the attenuation loss, which poses a problem in mounting in increasingly miniaturized devices.

As the EM-shielding material, an attention is recently paid to sheets of agglomerated CNTs. Because of a low electroconductivity as compared with metal foils such as aluminum and copper, it is still insufficient to take advantage of the agglomerated sheet.

### Citation List

Patent Document 1: JP-A 2009-144000
Patent Document 2: JP-A 2012-174833
Patent Document 3: JP-A 2015-187077

### DISCLOSURE OF INVENTION

An object of the invention is to provide an EM-shielding sheet comprising CNT nonwoven fabric, which exhibits EM-shielding properties to a full extent while minimizing the thickness of the nonwoven fabric, is easy to handle, and is suited to cover electronic parts and connections mounted in the interior of electronic equipment.

In one aspect, the invention provides an electromagnetic-shielding sheet comprising a carbon nanotube nonwoven fabric having a resistivity of 0.00005 to 0.05 Ω·cm and a thickness of 1 to 500 μm and a resin,

the sheet comprising
a multilayer film including at least two layers of the carbon nanotube nonwoven fabric and having a total thickness of 5 to 1,500 μm,
a pressure-sensitive adhesive layer disposed on one outermost surface of the multilayer film, and
a release film disposed on the adhesive surface of the pressure-sensitive adhesive layer.

In one embodiment, the multilayer film is a fabric/resin laminate including the carbon nanotube nonwoven fabric and a resin film disposed one on another.

Preferably, the resin film is a film of a thermoplastic resin having a softening point of up to 400°C.

The thermoplastic resin is preferably at least one resin selected from among polyethylene, polypropylene, fluorochemical resin, polyethylene terephthalate, polyethylene naphthalate, and polyimide.

Also preferably, the resin film is a film of a thermosetting resin which is at least one resin selected from among an epoxy resin, allylated epoxy resin, allylated polyphenylene ether resin, phenolic resin, polyimide resin, polyamide resin, bismaleimide resin, maleimide resin, cyanate resin, cyclopentadiene-styrene copolymer resin, polyester resin, silicone resin, and acrylic resin.

In another embodiment, the multilayer film is a prepreg laminate composed of at least two layers of carbon nanotube nonwoven fabric impregnated with the resin.

In a further embodiment, the multilayer film is a prepreg/fabric laminate including a prepreg film of carbon nanotube nonwoven fabric impregnated with the resin and a carbon nanotube nonwoven fabric layer disposed one on another.

In the other and further embodiments, the resin may contain at least one thermoplastic resin selected from among polyethylene, polypropylene, fluorochemical resin, polyethylene terephthalate, polyethylene naphthalate, and polyimide; or the resin may contain at least one thermosetting resin selected from among an epoxy resin, allylated epoxy resin, allylated polyphenylene ether resin, phenolic resin, polyimide resin, polyamide resin, bismaleimide resin, maleimide resin, cyanate resin, cyclopentadiene-styrene copolymer resin, polyester resin, silicone resin, and acrylic resin.

Preferably, the carbon nanotube nonwoven fabric is composed of single-walled carbon nanotubes, multi-walled carbon nanotubes or a mixture thereof.

## ADVANTAGEOUS EFFECTS

As compared with a shielding sheet comprising only one layer of carbon nanotube nonwoven fabric having a substantial thickness, the EM-shielding sheet comprising at least two layers of carbon nanotube nonwoven fabric having a reduced thickness exhibits equivalent EM-shielding performance. The shielding sheet can take full advantage of its properties as EM-shielding material.

## BRIEF DESCRIPTION OF DRAWINGS

FIG. 1A is a cross-sectional view schematically showing a first EM-shielding sheet comprising a carbon nanotube nonwoven fabric layer and a resin film.

FIG. 1B is a cross-sectional view schematically showing a second EM-shielding sheet in the form of prepreg laminate.

FIG. 1C is a cross-sectional view schematically showing a third EM-shielding sheet in the form of prepreg/fabric laminate.

FIG. 2 is a perspective view schematically showing the first EM-shielding sheet which is wound in roll form like glass cloth.

FIG. 3 is a perspective view schematically showing the roll of EM-shielding sheet from which a piece of tape is cut.

FIG. 4A is a cross-sectional view schematically showing a structure constructed by peeling the release film from the first EM-shielding sheet and attaching the sheet to the surface of an electronic part.

FIG. 4B is a cross-sectional view schematically showing a structure constructed by peeling the release film from the second EM-shielding sheet and attaching the sheet to the surface of an electronic part.

FIG. 4C is a cross-sectional view schematically showing a structure constructed by peeling the release film from the third EM-shielding sheet and attaching the sheet to the surface of an electronic part.

FIG. 5 is a perspective view schematically showing an example wherein a piece of tape cut from the EM-shielding sheet is wrapped around the surface of a copper wire.

FIG. 6 is a cross-sectional view schematically showing an example wherein a circuit board is covered in its entirety with the EM-shielding sheet, with some cross-sectional portions being not crosshatched.

FIG. 7 schematically shows a system for measuring EM-shielding properties in Examples.

## FURTHER EXPLANATIONS; OPTIONS AND PREFERENCES

Throughout the disclosure, the abbreviation EM stands for electromagnetic wave, CNT for carbon nanotube, PSA for adhesive, and EHF for extremely high frequency. The term "prepreg" refers to a CNT nonwoven fabric impregnated with a resin.

One embodiment of the invention is an EM-shielding sheet comprising a carbon nanotube (CNT) nonwoven fabric having a resistivity of 0.00005 to 0.05 Ω·cm and a thickness of 1 to 500 μm and a resin, the EM-shielding sheet comprising a multilayer film including at least two layers of CNT nonwoven fabric and having a total thickness of 5 to 1,500 μm, a PSA layer disposed on one outermost surface of the multilayer film, and a release film disposed on the adhesive surface of the PSA layer. No other particular limits are imposed as long as at least two layers of CNT nonwoven fabric are laid one on top of the other, as mentioned above. The number of CNT nonwoven fabric layers may be two or more. For example, the following three embodiments are included.

(1) The multilayer film is a fabric/resin laminate including a CNT nonwoven fabric layer and a resin layer, which are laid one on top of another.
(2) The multilayer film is a prepreg laminate including at least two layers of prepreg composed of CNT nonwoven fabric impregnated with resin, which are laid one on top of another.
(3) The multilayer film is a prepreg/fabric laminate including a prepreg layer of CNT nonwoven fabric impregnated with resin and a CNT nonwoven fabric layer, which are laid one on top of another.

The EM-shielding sheet comprises the multilayer film, which is specifically selected from the fabric/resin laminate (1), the prepreg laminate (2), and the prepreg/fabric laminate (3), a PSA layer laid on one outermost surface of the multilayer film, and a release film laid on the adhesive surface of the PSA layer.
Hereinafter, the EM-shielding sheet having the fabric/resin laminate (1) is referred to as first EM-shielding sheet, the EM-shielding sheet having the prepreg laminate (2) is referred to as second EM-shielding sheet, and the EM-shielding sheet having the prepreg/fabric laminate (3) is referred to as third EM-shielding sheet.

(1) An EM-shielding sheet comprising a CNT nonwoven fabric having a resistivity of 0.00005 to 0.05 Ω·cm and a thickness of 1 to 500 μm and a resin, the sheet comprising a multilayer film (or fabric/resin laminate) including at least two layers of CNT nonwoven fabric and a resin film and having a total thickness of 5 to 1,500 μm, a PSA layer disposed on one outermost surface of the multilayer film, and a release film disposed on the adhesive surface of the PSA layer.
(2) An EM-shielding sheet comprising a CNT nonwoven fabric having a resistivity of 0.00005 to 0.05 Ω·cm and a thickness of 1 to 500 μm and a resin, the sheet comprising a prepreg laminate including at least two layers of prepreg, i.e., CNT nonwoven fabric impregnated with a resin, and having a total thickness of 5 to 1,500 μm, a PSA layer disposed on one outermost surface of the multilayer film, and a release film disposed on the adhesive surface of the PSA layer.
(3) An EM-shielding sheet comprising a CNT nonwoven fabric having a resistivity of 0.00005 to 0.05 Ω·cm and a thickness of 1 to 500 μm and a resin, the sheet comprising a prepreg/fabric laminate including a prepreg layer of the CNT nonwoven fabric impregnated with a resin and a CNT nonwoven fabric layer and having a total thickness of 5 to 1,500 μm, a PSA layer disposed on one outermost surface of the multilayer film, and a release film disposed on the adhesive surface of the PSA layer.

For the multilayer film of the invention, it is essential to laminate two or more layers of CNT nonwoven fabric. It suffices that the multilayer film as a whole has two or more layers of CNT nonwoven fabric. The number of layers is not particularly limited as long as at least two layers are included. Two or three layers are preferred, with two layers being more preferred. When at least two layers of CNT nonwoven fabric are laid one on another, in the first embodiment, at least one layer is selected for each of CNT nonwoven fabric and resin film; in the second embodiment, two or more layers of prepreg are used; and in the third embodiment, at least one layer is selected for each of the prepreg and the CNT nonwoven fabric.

Carbon nanotube nonwoven fabric

The CNT nonwoven fabric used herein has a thickness of 1 to 500 μm, preferably 1 to 300 μm. The CNT nonwoven fabric is composed of a plurality of CNTs entangled. The CNTs of which CNT nonwoven fabric is composed are preferably single-walled CNTs, multi-walled CNTs, or a mixture thereof. Although the diameter and length of CNTs are not particularly limited, CNTs having a diameter of up to 50 nm and a length of up to 2 mm are generally used. The CNT nonwoven fabric used herein is preferably composed of a plurality of CNTs having a length of 10 to 500 μm entangled.
The CNTs may be prepared by reacting a carbon source such as methane with a catalyst such as ferrocene in a gas phase at a temperature of 1,000 to 1,500°C. For obtaining high electroconductivity, nonwoven fabric having a resistivity of 0.000005 to 0.05 Ω·cm, preferably 0.0001 to 0.01 Ω·cm, more preferably 0.0005 to 0.003 Ω·cm is used. It is noted that resistivity is measured according to JIS K7194: 1994, the testing method of resistivity of conductive plastics with a four-point probe array.
In the EM-shielding sheet, the CNT nonwoven fabric may take the form of CNT fibers covered on their surface with a silica layer. For example, by treating CNT nonwoven fabric with a polysilazane compound, a silica layer can be

formed on the surface of fibers of the CNT fabric.

In the EM-shielding sheet, for rendering the CNT nonwoven fabric more wettable with thermosetting resins such as epoxy resins, allylated epoxy resins, allylated polyphenylene ether resins, phenolic resins, polyimide resins, polyamide resins, bismaleimide resins, maleimide resins, cyanate resins, cyclopentadiene-styrene copolymer resins, polyester resins, silicone resins and acrylic resins, the CNT nonwoven fabric may be treated on fiber surfaces with a sizing agent, that is, a dilute solution of the thermosetting resin.

By surface treatment of the CNT nonwoven fabric with a coupling agent, the CNT nonwoven fabric and the resin are more tightly bonded whereby the EM-shielding sheet is made more durable. The coupling agent used herein may be selected from silane coupling agents and alkoxide compounds of titanium and aluminum. Inter alia, silane coupling agents are preferred. Preferred examples of the silane coupling agent include organosilicon compounds having the formula (1):

$$Y\text{-}Si\text{-}X_3 \qquad (1)$$

wherein Y is an organic group having a reactive functional group and X is a hydrolyzable group.

Examples of the organic group Y include amino, epoxy, hydroxy, carboxyl, vinyl, methacryloyl, and mercapto. Exemplary of X are alkoxy groups. Examples of the organosilicon compound having formula (1) include γ-glycidoxypropyltrimethoxysilane, vinyltriethoxysilane, γ-aminopropyltriethoxysilane, γ-mercaptopropyltrimethoxysilane, γ-methacryloxypropyltrimethoxysilane, γ-aminobenzyltriethoxysilane, and γ-aminophenyltriethoxysilane. Silane compounds such as polysilazane are also useful.

In the EM-shielding sheet, an inorganic material may be added to the CNT nonwoven fabric. Suitable inorganic materials include electroconductive inorganic materials and insulating inorganic materials. By introducing inorganic particles, inorganic fibers or metal particles into gaps of entangled CNT nonwoven fabric fibers, it is possible to increase electroconductivity and to enhance EM-shielding performance in the frequency band from EHF to terahertz. Of conductive inorganic materials, suitable inorganic particles include carbon black, CNTs, graphene, and graphite, suitable inorganic fibers include carbon short fibers, and suitable metal particles include those of copper, iron, silver, gold and other metals. Resin particles coated on their surface with such a metal may also be used as the conductive inorganic material.

The thermal conductivity of CNT nonwoven fabric can be enhanced by using inorganic particles or fibers as the insulating inorganic material having a high thermal conductivity. For example, the CNT nonwoven fabric can be provided with a thermal conductivity of 50 to 80 W/mK. Of the insulating inorganic materials, inorganic particles such as silica, zinc oxide, alumina, boron nitride, and aluminum nitride are suitable. Suitable inorganic fibers include alumina short fibers, quartz fibers, and glass fibers.

Although the shape of inorganic material is not particularly limited, a powder having an average particle size of 0.5 to 30 μm is preferred from the aspects of heat dissipation and electroconductivity. The average particle size of inorganic material is a cumulative average diameter $D_{50}$ or median diameter in the volume average particle diameter as measured by the laser diffractometry.

The inorganic material can be fixed to the CNT nonwoven fabric by directly applying it. The inorganic material may be applied to the CNT nonwoven fabric by any desired methods, for example, a method of packing the inorganic material into the CNT nonwoven fabric by means of a press or laminator; a method of dispersing the inorganic material in any desired solvent, spraying the dispersion to the CNT nonwoven fabric, and drying to remove the solvent; or combinations thereof.

The solvent in the dispersion may be selected from a variety of solvents, preferably volatile solvents, for example, water, alcohols such as ethanol and isopropyl alcohol, acetone, toluene, hydrocarbon solvents, and silicone solvents. The concentration of the dispersion is preferably 0.1 to 100 parts by weight of the solvent per 100 parts by weight of the inorganic material. When the inorganic material is fixed to the CNT nonwoven fabric by applying, the amount of the inorganic material fixed is preferably 0.01 to 1,000 parts by weight per 100 parts by weight of the CNT nonwoven fabric. Further, a metal foil such as copper or aluminum may be laid on the CNT nonwoven fabric.

## Resin film of the EM-shielding sheet

As defined above, one embodiment of the invention is an EM-shielding sheet comprising a CNT nonwoven fabric having a resistivity of 0.00005 to 0.05 Ω·cm and a thickness of 1 to 500 μm and a resin, the EM-shielding sheet comprising a multilayer film including at least two layers of CNT nonwoven fabric and having a total thickness of 5 to 1,500 μm, a PSA layer disposed on one outermost surface of the multilayer film, and a release film disposed on the adhesive surface of the PSA layer. Furthermore, a protective layer may be disposed on the outermost surface of the multilayer film opposite to the PSA layer. The protective layer will be described later.

Resin film in the first embodiment

The first embodiment of the invention is an EM-shielding sheet comprising a CNT nonwoven fabric having a resistivity of 0.00005 to 0.05 Ω·cm and a thickness of 1 to 500 μm and a resin, the sheet comprising a multilayer film (or fabric/resin laminate) including at least two layers of the CNT nonwoven fabric and a resin film and having a total thickness of 5 to 1,500 μm, a PSA layer disposed on one outermost surface of the multilayer film, and a release film disposed on the adhesive surface of the PSA layer.

The resin film and protective layer may be a thermoplastic or thermosetting resin film.

The thermoplastic resin film is made of a thermoplastic resin having a softening point of preferably up to 400°C, more preferably up to 300°C, as viewed from the standpoints of film formation and working of EM-shielding sheet. The lower limit of softening point is, for example, at least 70°C though not critical. The softening point of a thermoplastic resin is measured by JIS K7196-1991: the testing method for softening temperature of thermoplastic film and sheeting by thermomechanical analysis.

Examples of the thermoplastic resin of the thermoplastic resin film include polyethylene, polypropylene, fluorochemical resin, polyethylene terephthalate, polyethylene naphthalate, polyimide, polyphenylene ether, polyether ether ketone, polyether ketone, and polyether sulfone, which may be used alone or in admixture. Inter alia, from the aspect of working of EM-shielding sheet, polyethylene, polypropylene, fluorochemical resin, polyethylene terephthalate, polyethylene naphthalate, and polyimide are preferred, with polyethylene, polypropylene, polyethylene terephthalate and polyethylene naphthalate being more preferred. When heat resistance is required, polyimide film is preferred. When chemical resistance and solvent resistance are required, fluorochemical resin film is preferred. Any of well-known additives and other components may be added to the thermoplastic resin as long as the benefits of the invention are not impaired.

The thermoplastic resin film preferably has a thickness of 5 to 200 μm, more preferably 10 to 100 μm.

Thermosetting resin film of first EM-shielding sheet

In the first EM-shielding sheet, the thermosetting resin of the thermosetting resin film is selected from epoxy resins, allylated epoxy resins, allylated polyphenylene ether resins, phenolic resins, polyimide resins, polyamide resins, bismaleimide resins, maleimide resins, cyanate resins, cyclopentadiene-styrene copolymer resins, polyester resins, silicone resins, and acrylic resins, which may be used alone or in admixture. Inter alia, silicone resins and bismaleimide resins are preferred from the aspects of heat resistance and flexibility.

The silicone resin of which the thermosetting resin film is made is not particularly limited as long as it is thermosetting. Preference is given to an addition-curable silicone resin composition containing an alkenyl-containing organopolysiloxane, an organohydrogenpolysiloxane, and a hydrosilation catalyst, and a condensation-curable silicone resin composition containing an alkoxysilyl and/or hydroxysilyl-containing organopolysiloxane and a condensation catalyst. From the aspects of various properties including workability, storage stability, transparency and electric properties, the addition-curable silicone resin composition is preferred. Typically the addition-curable silicone resin composition contains (A) an alkenyl-containing organopolysiloxane of resinous structure, (B) an organohydrogenpolysiloxane of resinous structure, and (C) a platinum group metal-based catalyst.

The bismaleimide resin of which the thermosetting resin film is made is preferably a bismaleimide resin composition comprising a bismaleimide resin having a dimer acid skeleton in the molecule and a reaction initiator. Any of well-known additives and other components may be added to the thermosetting resin composition as long as the benefits of the invention are not impaired.

The thermosetting resin film is preferably pre-formed by sheeting a thermosetting resin into a film having a thickness of 5 to 200 μm, more preferably 10 to 100 μm.

Resin in prepreg of second and third EM-shielding sheets

The prepreg film used in the second and third EM-shielding sheets is a film of CNT nonwoven fabric impregnated with a resin, which may be either a thermoplastic or thermosetting resin.

In the second and third EM-shielding sheets, the thermoplastic resin in the prepreg film is used in liquid form by dissolving the thermoplastic resin in a solvent to form a solution, or in the case of fluorochemical resin, dispersing the resin in a dispersing medium such as water to form a slurry. Then, the CNT nonwoven fabric is impregnated with the solution or slurry. After the CNT nonwoven fabric is impregnated with the solution or slurry of the thermoplastic resin, the fabric is heat dried to remove the solvent or dispersing medium, yielding a prepreg film.

In the second and third EM-shielding sheets, the thermoplastic resin in the prepreg film is selected from polyethylene, polypropylene, fluorochemical resin, polyethylene terephthalate, polyethylene naphthalate, polyimide, polyphenylene ether, polyether ether ketone, polyether ketone, and polyether sulfone, which may be used alone or in

admixture. Inter alia, polyethylene, polypropylene, fluorochemical resin, polyethylene terephthalate, polyethylene naphthalate, and polyimide are preferred. Any of well-known additives and other components may be added to the thermoplastic resin as long as the benefits of the invention are not impaired.

In the second and third EM-shielding sheets, the thermosetting resin in the prepreg film is selected from epoxy resins, allylated epoxy resins, allylated polyphenylene ether resins, phenolic resins, polyimide resins, polyamide resins, bismaleimide resins, maleimide resins, cyanate resins, cyclopentadiene-styrene copolymer resins, polyester resins, silicone resins and acrylic resins, which may be used alone or in admixture. Inter alia, epoxy resins and bismaleimide resins are preferred.

Of the epoxy resins, those having two or more glycidyl groups in the molecule are preferred. Examples of the epoxy resin include bisphenol type epoxy resins such as bisphenol A epoxy resins, bisphenol F epoxy resins, bisphenol AD epoxy resins, and bisphenol S epoxy resins; epoxy resins having a biphenyl skeleton, epoxy resins having a naphthalene skeleton, epoxy resins having a dicyclopentadiene skeleton; novolak epoxy resins such as phenol novolak epoxy resins and cresol novolak epoxy resins; and polyfunctional epoxy resins, which may be used alone or in admixture.

As the curing agent for epoxy resins, a curing agent containing a phenolic hydroxy or amino group having active hydrogen and capable of forming a crosslinking structure with an epoxy resin may be used. The curing agent containing a phenolic hydroxy group may be any of phenolic resins having a phenolic hydroxy group. The curing agent containing an amino group is preferably an aromatic amine curing agent because an epoxy resin cured product having high heat resistance and a high modulus of elasticity is obtained.

Of the bismaleimide resins, those having a dimer acid skeleton in the molecule are preferred because of heat resistance, low elasticity, toughness, and adhesiveness.
Typical of the bismaleimide resin are SLK-6895 and SLK-3000 as well as SLK-2000 series (all from Shin-Etsu Chemical Co., Ltd.).

For impregnation, 10 to 1,000 parts by weight of the bismaleimide resin is preferably used per 100 parts by weight of the CNT nonwoven fabric.

When the bismaleimide resin is used as the thermosetting resin, a reaction initiator for bismaleimide resins is preferably used along with the curing catalyst. The reaction initiator for bismaleimide resins is not particularly limited as long as it promotes crosslinking reaction. Examples of the reaction initiator include ionic catalysts such as imidazoles, organophosphorus compounds, tertiary amines, quaternary ammonium salts, boron trifluoride amine complexes, organophosphines, organophosphonium salts; organic peroxides such as diallyl peroxide, dialkyl peroxides, peroxide carbonate, and hydroperoxides; and radical polymerization initiators such as azoisobutyronitrile.

Of these, organic peroxides are preferred. Examples thereof include dicumyl peroxide, t-butyl peroxybenzoate, t-amyl peroxybenzoate, dibenzoyl peroxide, dilauroyl peroxide, 2,5-dimethyl-2,5-di(t-butylperoxy)hexane, 1,1-di(t-butylperoxy)cyclohexane, di-t-butyl peroxide, and dibenzoyl peroxide.

The amount of the reaction initiator used is preferably 0.05 to 10 parts by weight, more preferably 0.1 to 5 parts by weight per 100 parts by weight of the bismaleimide resin. The reaction initiator may be used alone or in admixture.

Any of well-known additives and other components may be added to the thermosetting resin in the prepreg film as long as the benefits of the invention are not impaired.

The amount of the resin used for impregnation is preferably 10 to 1,000 parts by weight, more preferably 200 to 400 parts by weight per 100 parts by weight of the CNT nonwoven fabric.

<u>Additives to resin in EM-shielding sheet</u>

In the EM-shielding sheet, any of well-known additives and other components may be used as long as the benefits of the invention are not impaired. Suitable other components include coupling agents and inorganic materials. The coupling agent and/or inorganic material may be added to any of the thermoplastic and thermosetting resin films in the first embodiment or any of the thermoplastic and thermosetting resins in the second embodiment, preferably to the thermosetting resin composition of which the thermosetting resin film is made.

The coupling agent is useful for improving the wettability and bond strength between the CNT nonwoven fabric and the resin. Suitable coupling agents are as exemplified above as the coupling agent to be added to the CNT nonwoven fabric.

When added, the amount of the coupling agent used is preferably 0.5 to 20 parts by weight per 100 parts by weight of the thermoplastic or thermosetting resin. When the coupling agent is added to the thermoplastic resin, the preferred procedure involves dissolving the thermoplastic resin in a solvent and adding the coupling agent to the solution.

Suitable inorganic materials include electroconductive inorganic materials and insulating inorganic materials. The conductive inorganic material makes it possible to further increase electroconductivity and to enhance EM-shielding performance in the frequency band from EHF to terahertz. The insulating inorganic material makes it possible to further increase the thermal conductivity of the CNT nonwoven fabric. Examples of the conductive and insulating inorganic materials are as exemplified above as such materials to be added to the CNT nonwoven fabric.

In the first EM-shielding sheet, the inorganic material may be incorporated in the thermoplastic or thermosetting resin film. In the second EM-shielding sheet, the inorganic material may be dispersed in the thermoplastic or thermosetting resin, and the CNT nonwoven fabric be impregnated with the dispersion. When added, the amount of the inorganic material used is preferably 5 to 60 parts by weight, more preferably 10 to 50 parts by weight per 100 parts by weight of the thermoplastic or thermosetting resin.

The multilayer film has a total thickness of 5 to 1,500 μm, preferably 5 to 1,000 μm, more preferably 10 to 500 μm, even more preferably 60 to 90 μm, most preferably 34 to 90 μm. As long as the total thickness of the multilayer film is in the range, the characteristics of EM-shielding material based on CNTs are fully exerted. It is noted that the total thickness of the multilayer film is the thickness of films or layers excluding the PSA layer and release film. When a protective layer is formed, its thickness is included in the total thickness of the multilayer film.

Multilayer film in first EM-shielding sheet

In the first EM-shielding sheet, the multilayer film is a fabric/resin laminate including a CNT nonwoven fabric layer and a resin film. The multilayer film or fabric/resin laminate has a total thickness of 5 to 1,500 μm, preferably 10 to 500 μm, more preferably 34 to 90 μm. As long as the total thickness of the multilayer film is in the range, the characteristics of EM-shielding material based on CNTs are fully exerted. A structure wherein a release film is attached to the multilayer film via the PSA layer is easy to handle.

It is noted that the total thickness of the multilayer film is the thickness of the multilayer film as finished. When the thermoplastic resin film is laminated to the CNT nonwoven fabric by heating and pressing, the total thickness is the thickness of the resulting laminate. When the resin film is a thermosetting resin film and cured after lamination, the total thickness is the thickness of the laminate as cured.

Multilayer film in second EM-shielding sheet

In the second and third EM-shielding sheets, the prepreg film is CNT nonwoven fabric impregnated with a thermoplastic or thermosetting resin. The prepreg films have a total thickness of preferably 2.5 to 500 μm, more preferably 5 to 250 μm, even more preferably 30 to 100 μm.

In the second EM-shielding sheet, the multilayer film is a prepreg laminate composed of two or more prepreg films (i.e., CNT nonwoven fabric impregnated with resin). The prepreg laminate has a total thickness of 5 to 1,500 μm, preferably 5 to 1,000 μm, more preferably 10 to 500 μm, even more preferably 60 to 90 μm. As long as the total thickness of the multilayer film is in the range, the characteristics of EM-shielding material based on CNTs are fully exerted.

Multilayer film in third EM-shielding sheet

In the third EM-shielding sheet, the multilayer film is a prepreg/fabric laminate composed of a prepreg film (i.e., CNT nonwoven fabric impregnated with a resin) or a multilayer prepreg film consisting of two or more prepreg films, and a CNT nonwoven fabric layer laid thereon. The multilayer film has a total thickness of 5 to 1,500 μm, preferably 10 to 500 μm, more preferably 20 to 90 μm. As long as the total thickness of the multilayer film is in the range, the characteristics of EM-shielding material based on CNTs are fully exerted.

It is noted that the total thickness of the prepreg laminate or prepreg/fabric laminate is the thickness of such laminate as finished. When CNT nonwoven fabric is impregnated with the thermoplastic resin solution and the solvent is removed by heat drying, the total thickness is based on the thickness of the resulting prepreg. When CNT nonwoven fabric is impregnated with the thermosetting resin and the resin is then cured, the total thickness is based on the thickness of the prepreg as cured.

As defined above, the EM-shielding sheet further includes a PSA layer disposed on one outermost surface of the multilayer film and a release film disposed on the adhesive surface of the PSA layer. The outermost surface refers to the outermost surface of any embodiment, that is, the surface of one prepreg film in the second EM-shielding sheet or the surface of the fabric in the fabric/prepreg laminate in the third EM-shielding sheet.

PSA layer

In the EM-shielding sheet, a PSA is used to bond and fix the sheet to the surface of an electronic part or circuit board. Any commercially available PSAs may be used. Preferably acrylic and silicone resin-based PSAs are used because resins having a wide range of adhesive force are available.

Typical of the silicone resin-based PSA are KR100, KR130, KR3701 and KR3704 (all from Shin-Etsu Chemical Co., Ltd.). A PSA layer is formed, for example, by diluting the PSA with a solvent such as toluene, adding a catalyst thereto, coating the dilution onto one surface of the EM-shielding sheet, heating the sheet at a temperature of 100 to 150°C for

several minutes to remove the solvent and promote thermosetting. The thickness of the PSA layer can be adjusted in accordance with the concentration of the dilution. The bonding force can be readily adjusted by mixing a light-adhesive agent and a heavy-adhesive agent. A thermosetting adhesive agent or PSA may also be used when the EM-shielding sheet is attached to a heat resistant member. The PSA layer preferably has a thickness of 5 to 100 μm, more preferably 10 to 70 μm.

Release film

The release film used in the EM-shielding sheet may be selected from polypropylene, PET, polyethylene, and fluorochemical resin films. When it is difficult to peel the release film from the PSA layer coated to the EM-shielding sheet, the release film may be pretreated with a release agent.

The release film preferably has a thickness of 10 to 50 μm for ease of use. A satinized film may also be used as the release film.

Preparation of EM-shielding sheet

The first EM-shielding sheet may be prepared, for example, by a melt rolling method including laying a resin film and a CNT nonwoven fabric one on top of another, heating them to a lower viscosity, and rolling for lamination; or a transfer method including sheeting a resin varnish into a film by means of a coater, and transferring the film to a CNT nonwoven fabric by means of a press or laminator. As mentioned above, either a thermoplastic or thermosetting resin film may be used as the resin film. The thermosetting resin film may be any of uncured, semi-cured and fully cured resin films.

The melt rolling method has several advantages including no need for solvent removal and an acceptable working environment. The melt rolling method typically includes the steps of widening CNT nonwoven fabric to a necessary width by a bar or the like, sandwiching a thermoplastic or thermosetting resin film between the fabrics via release paper, feeding the sandwich, with the release paper taken off, through several pairs of heating metal rolls arranged at a substantially equal height relative to the advancing direction for nipping, and heat pressing the thermoplastic or thermosetting resin to the fabrics. Since the nipping pressure in the melt rolling method is linear, it is recommended to increase the number of nip rolls for achieving sufficient heat pressing. Instead of the heating metal rolls, a shaping press such as multi-stage press with a heating capability may be used for pressure shaping.

The transfer method typically includes the steps of coating a resin varnish to a substrate film, drying off the solvent to form a resin film, laying CNT nonwoven fabric and the resin film one on top of another, and pressing them by means of a press or laminator for transferring the resin film to the CNT nonwoven fabric. Any desired film may be used as the substrate film. Resin films are preferred because of easy peeling, for example, PET films, PE films, PP films, Teflon® films, and Fluon® films.

The substrate film may be subjected to surface treatment such as corona treatment, plasma treatment or silicone treatment, if necessary. For the resin varnish, any desired solvent may be selected. Volatile solvents are preferred, for example, alcohols such as ethanol and isopropyl alcohol, acetone, toluene, xylene, anisole, hydrocarbon solvents, and silicone solvents.

The resin varnish is preferably adjusted to such a concentration that 0.1 to 200 parts by weight of the solvent may be present per 100 parts by weight of the resin. Any desired method may be used in coating the resin varnish to the substrate film. A spin coater or bar coater is preferred because of ease of coating. The resin coating on the substrate film is dried at a temperature at which the thermosetting resin remains unreactive, preferably of 30 to 120°C.

In the steps of laying CNT nonwoven fabric and a resin film one on top of another, and contact bonding them by means of a press or laminator for transferring the resin film to the CNT nonwoven fabric, pressure and/or heat may be applied if necessary.

Once the resin film and the CNT nonwoven fabric are laminated by the aforementioned method, in the case of thermosetting resin film, the semi-cured thermosetting resin film is cured with the aid of heat and pressure, if necessary, yielding an EM-shielding sheet. By properly selecting the chemical structure of the thermoplastic or thermosetting resin in the resin film and the curing system of the thermosetting resin, a variety of multilayer films ranging from a hard and tough multilayer film to a flexible, shape-conformable multilayer film can be prepared.

The prepreg in the second and third EM-shielding sheet may be prepared, for example, by the wet method involving the steps of dissolving a thermoplastic or thermosetting resin in a solvent or dispersing the resin in a dispersing medium, to form a low viscosity solution or dispersion, and impregnating the CNT nonwoven fabric with the solution or dispersion.

The wet method involves the steps of impregnating CNT nonwoven fabric with a thermoplastic or thermosetting resin, removing the volatile solvent or dispersing medium to form a prepreg, i.e., fabric impregnated with the thermoplastic resin or uncured thermosetting resin. If the solvent is left in the prepreg, it gives a detrimental influence in the subsequent shaping step and aggravates the working environment. For this reason, the amount of the solvent left in the prepreg should

preferably be up to 1% by weight, more preferably up to 0.5% by weight. The removal of solvent is readily achieved by heat treatment at 80 to 150°C for about 10 minutes to 1 hour although the conditions vary with the boiling point of the solvent.

A prepreg laminate is prepared by laying two or more layers of the prepreg one on top of another and heat pressing them. By laying the prepreg or prepreg/fabric laminate and a CNT nonwoven fabric one on top of another and heat pressing, the thermoplastic resin multilayer film or cured thermosetting resin multilayer film is prepared.

Thereafter, a PSA layer is disposed on the outermost surface of the multilayer film, specifically the outermost surface of the fabric/resin laminate in the first EM-shielding sheet, the outermost surface of the prepreg laminate in the second EM-shielding sheet, or the outermost surface of the prepreg/fabric laminate in the third EM-shielding sheet. A release film is disposed on the adhesive surface of the PSA layer, completing the EM-shielding sheet of the invention. The outermost surface is not particularly limited as long as it is the surface of the outer layer of any laminate in each embodiment.

The EM-shielding sheet preferably has a total thickness of 10 to 1,600 μm, more preferably 10 to 1,500 μm, even more preferably 15 to 500 μm.

By the shaping procedure mentioned above, the EM-shielding sheet having the desired thickness and a large area is prepared. It is subsequently supplied in a sheet form or in a roll form wound on a paper core.

The EM-shielding sheet of the invention processed as above has many advantages including a light weight, satisfactory EM-shielding properties, ease of processing, and ease of use. The EM-shielding sheet is thus suited as members which must have satisfactory EM-shielding properties, for example, surface coatings on electronic circuit boards having a plurality of electronic parts mounted thereon, containers of EM-generating vehicle batteries, motor members, DC/DC converter sealing materials, as well as members or containers for communication equipment using a high frequency of EHF or higher and requiring heat resistance.

FIG. 1A is a schematic cross-sectional view showing one exemplary first EM-shielding sheet. The EM-shielding sheet 1a is an EM-shielding sheet of 6-layer structure comprising a 4-layer laminate consisting of CNT nonwoven fabric layers 2, a resin film 3 and a protective layer 4, a PSA layer 5 laid on the surface of CNT nonwoven fabric layer 2, and a release film 6 laid on the adhesive surface of the PSA layer 5.

The EM-shielding sheet 1a is manufactured by furnishing an EM-shielding sheet having a predetermined thickness and a large surface area by the shaping method as mentioned above, rounding the EM-shielding sheet into a roll 8 like glass cloth as shown in FIG. 2, and cutting the EM-shielding sheet from the roll 8 into a piece of tape 9 as shown in FIG. 3, which is used as an EM-shielding sheet.

On use of the first EM-shielding sheet 1a of 6-layer structure, the release film 6 is peeled therefrom, and the EM-shielding sheet (9) is attached to the surface of an electronic part 11 on a printed circuit board 10 as shown in FIG. 4A, whereby the electronic part 11 is shielded from EM.

Similarly, the second EM-shielding sheet 1b of 4-layer structure shown in FIG. 1B is an EM-shielding sheet comprising prepreg laminates 7 of resin-impregnated CNT nonwoven fabric, a PSA layer 5 laid on the surface of one prepreg film 7, and a release film 6 laid on the adhesive surface of the PSA layer 5. On use, for example, the release film 6 is peeled therefrom, and the prepreg laminate is attached to the surface of an electronic part 11 on a printed circuit board 10 as shown in FIG. 4B, whereby the electronic part 11 is shielded from EM.

FIG. 1C is a cross-sectional view schematically showing one exemplary third EM-shielding sheet comprising a prepreg film 7 and a CNT nonwoven fabric layer 2 laid thereon.

As shown in FIG. 5, a piece of tape 9 cut from the EM-shielding sheet is wound on the surface of a copper conductor 12 whereby the conductor 12 is shielded from EM. As shown in FIG. 6, in the case of the first EM-shielding sheet 1a of 6-layer structure, for example, the release film 6 is peeled therefrom, and the shielding sheet is attached to a circuit board 13 including the surface of electronic parts 11 on a printed circuit board 10 so as to cover the entire circuit board 13 whereby the electronic parts 11 are shielded from EM. It is noted that in FIG. 4, a section of identical parallel crosshatches shows a single layer. In FIG. 6, some sections are not crosshatched.

## EXAMPLES

Examples are shown below by way of illustration, but not by way of limitation. The materials used in Examples are shown below. Physical properties are measured by the methods described below.

### Materials

(1) CNT nonwoven fabric

[Nonwoven fabric #1]

A dispersion was prepared by stirring 100 parts by weight of water, 0.4 part by weight of single-walled CNTs

(EC1.5P, Meijo Nano Carbon Co., Ltd.), and 0.4 part by weight of ionic surfactant, sodium deoxycholate (FUJIFILM Wako Pure Chemical Corp.) in a mixer (IFM-800DGM, Iwatani Corp.). The dispersion was coated onto a release-treated PET film (E7006, Toyobo Co., Ltd.) by means of a doctor blade with a clearance of 1.5 mm. The coating was dried at 100°C for 1 hour and peeled from the PET film, obtaining a nonwoven fabric. The ionic surfactant-containing single-walled CNT nonwoven fabric had a thickness of 10 μm and a resistivity of 0.00075 Ω·cm.

[Nonwoven fabric #2]

MIRALON T01 (Huntsman Corp.)
thickness 20 μm, resistivity 0.0015 Ω·cm

[Nonwoven fabric #3]

CNTM30 (Tortech Nano Fibers)
thickness 85 μm, resistivity 0.0015 Ω·cm

(2) Resin

[Thermosetting resin #1]
uncured film of addition cure silicone resin of 10 μm thick (LPS-AF500D, Shin-Etsu Chemical Co., Ltd.)

[Thermosetting resin #2]
bismaleimide resin of the following formula (2) (SLK-3000, Shin-Etsu Chemical Co., Ltd., Mn=5,200)

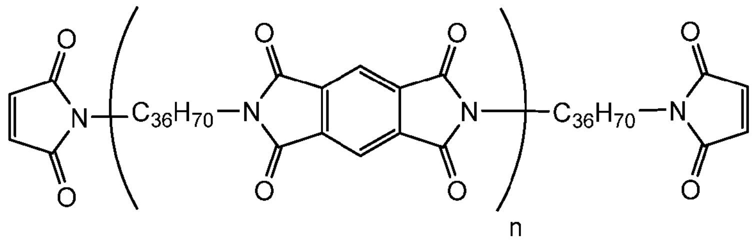

(2)

n= ~5 (average)

[Thermoplastic resin #1]
PET film of 25 μm thick (E5100, Toyobo Co., Ltd.)

[Thermoplastic resin #2]
PET film of 50 μm thick (E5100, Toyobo Co., Ltd.)

(3) PSA #1
silicone PSA (KR3704, Shin-Etsu Chemical Co., Ltd.)

(4) Release film #1
fluorochemical resin film of 50 μm thick (Fluon®, AGC)

Measuring methods

(1) Resistivity

The surface resistivity of CNT nonwoven fabric was measured according to JIS K7194: 1994, the testing method

of resistivity of conductive plastics with a four-point probe array. Measurement was made by low resistivity meter Loresta-GX MCP-T700 (Nittoseiko Analytech Co., Ltd. From the measured value, the resistivity was computed according to the following equation.

$$\text{resistivity } (\Omega\cdot\text{cm}) = \text{surface resistivity } (\Omega/\text{cm}^2) \times \text{thickness (cm)}$$

(2) EM-shielding properties

EM-shielding properties were analyzed by cutting an EM-shielding sheet into a specimen of 12 cm squares and measuring the transmission attenuation at 28 GHz and 77 GHz by means of EM shield analyzer (Keycom Corp.). FIG. 7 schematically shows a system for measuring EM-shielding properties. The specimen 14 was set between two antennas 15 which were arrayed on y axis and coupled to a vector network analyzer such that the plane of the specimen, EM-shielding sheet was perpendicular to y axis. Incident wave 16 was EM having the vibration of electric field in z axis direction. The EM transmitted by the specimen was measured, from which a transmission attenuation (dB) was computed. The vector network analyzer was equipped with MS46122B (Anritsu Corp.) for 28 GHz measurement and MS46522B (Anritsu Corp.) for 77 GHz measurement.

Example 1 (first embodiment)

A multilayer film (fabric/resin laminate) of 4-layer structure having a total thickness of 32 μm was prepared by alternately laying thermosetting resin film #1 and nonwoven fabric #1 one on top of another, heat pressing them at 80°C, and curing in a dryer at 150°C for 4 hours. PSA #1 was coated onto the surface of nonwoven fabric #1 of this four-layer film, and heat cured at 100°C for 1 hour to form a PSA layer of 10 μm thick. Release film #1 was attached to the PSA layer, completing an EM-shielding sheet of 6-layer structure.

The EM-shielding sheet was examined for shielding performance by measuring the transmission attenuation by the aforementioned measuring method. The results are shown in Table 1. After the release film was peeled off, the sheet was laid over an electronic circuit board having semiconductor devices mounted thereon, yielding a shielding sheet-covered circuit board in which the shielding sheet conformed to irregularities on the circuit surface as shown in FIG. 4A. The shielding sheet could be readily peeled from the circuit board.

Example 2 (first embodiment)

A multilayer film (fabric/resin laminate) of 3-layer structure was prepared by laying nonwoven fabric #1 on opposite surfaces of thermoplastic resin film #1, and heat pressing them at 240°C. A film of thermosetting resin #1 as protective layer was rested on one surface of the three-layer film, heat pressed at 80°C, and cured in a dryer at 150°C for 4 hours, completing a multilayer film of 4-layer structure having a total thickness of 51 μm. PSA #1 was coated onto the surface of nonwoven fabric #1 of this four-layer film, and heat cured at 150°C for 1 hour to form a PSA layer of 10 μm thick. Release film #1 was attached to the PSA layer, completing an EM-shielding sheet of 6-layer structure.

Example 3 (first embodiment)

An EM-shielding sheet was prepared as in Example 2 aside from using thermoplastic film #2 instead of thermoplastic resin film #1. The multilayer film (fabric/resin laminate) had a total thickness of 76 μm.

Example 4 (second embodiment)

A toluene solution was prepared by mixing 100 parts by weight of thermosetting resin #2, 1 part by weight of a curing catalyst (dicumyl peroxide, available as Percumyl D from NOF Corp.), and 200 parts by weight of toluene. Nonwoven fabric #1 was impregnated with the toluene solution and heated at 100°C for 10 minutes to remove toluene, obtaining a semi-cured prepreg of 35 μm thick. Two prepreg films were laid one on another and heat-pressed at 180°C and 0.5 MPa for 1 hour for curing, obtaining a prepreg laminate having a total thickness of 76 μm. PSA #1 was coated onto one surface of the prepreg laminate, and heat cured to form a PSA layer of 10 μm thick. Release film #1 was attached to the PSA layer, completing an EM-shielding sheet of 4-layer structure.

Example 5 (first embodiment)

An EM-shielding sheet was prepared as in Example 2 aside from using nonwoven fabric #2 instead of nonwoven

fabric #1. The multilayer film (prepreg laminate) had a total thickness of 71 μm.

Example 6 (third embodiment)

A toluene solution was prepared by mixing 100 parts by weight of thermosetting resin #2, 1 part by weight of a curing catalyst (dicumyl peroxide, available as Percumyl D from NOF Corp.), and 200 parts by weight of toluene. Nonwoven fabric #2 was impregnated with the toluene solution and heated at 100°C for 10 minutes to remove toluene, obtaining a semi-cured prepreg of 40 μm thick. The prepreg film and nonwoven fabric #1 were laid one on another and heat-pressed at 180°C and 0.5 MPa for 1 hour for curing, obtaining a prepreg/fabric laminate having a total thickness of 48 μm. PSA #1 was coated onto one surface of nonwoven fabric #1 of the prepreg/fabric laminate, and heat cured to form a PSA layer of 10 μm thick. Release film #1 was attached to the PSA layer, completing an EM-shielding sheet of 4-layer structure.

Comparative Example 1

Thermosetting resin film #1 as protective layer was laid on nonwoven fabric #1, heat-pressed at 80°C, and cured in a dryer at 150°C for 4 hours, obtaining a multilayer film of 2-layer structure having a total thickness of 16 μm. PSA #1 was coated onto one surface of nonwoven fabric #1, and heat cured at 150°C for 1 hour to form a PSA layer of 10 μm thick. Release film #1 was attached to the PSA layer, completing an EM-shielding sheet of 4-layer structure.

The EM-shielding sheet was examined for shielding performance by measuring the transmission attenuation by the aforementioned measuring method. The results are shown in Table 1. After the release film was peeled off, the sheet was applied to an electronic circuit board having semiconductor devices mounted thereon, yielding a shielding sheet-covered circuit board in which the shielding sheet conformed to irregularities on the circuit surface. The shielding sheet could be readily peeled from the circuit board.

Comparative Example 2

An EM-shielding sheet was prepared as in Comparative Example 1 aside from using nonwoven fabric #2 instead of nonwoven fabric #1. The multilayer film had a total thickness of 34 μm.

Comparative Example 3

An EM-shielding sheet was prepared as in Comparative Example 1 aside from using nonwoven fabric #3 instead of nonwoven fabric #1. The multilayer film had a total thickness of 91 μm.

Table 1

| | | Example 1 | Example 2 | Example 3 | Example 4 | Example 5 | Example 6 |
|---|---|---|---|---|---|---|---|
| CNT nonwoven fabric | | Nonwoven fabric #1 | Nonwoven fabric #1 | Nonwoven fabric #1 | Nonwoven fabric #2 | Nonwoven fabric #2 | Nonwoven fabric #1, #2 |
| Protective layer | | Thermosetting resin #1 | Thermosetting resin #1 | Thermosetting resin #1 | - | Thermosetting resin #1 | - |
| Resin for laying or impregnation | | Thermosetting resin #1 | Thermoplastic resin film #1 | Thermoplastic resin film #2 | Thermosetting resin #2 | Thermoplastic resin film #1 | Thermosetting resin #2 |
| Embodiment of shielding sheet | | first | first | first | second | first | third |
| Number of CNT nonwoven fabric layers | | 2 | 2 | 2 | 2 | 2 | 2 |
| Total thickness of multilayer film, μm | | 32 | 51 | 76 | 76 | 71 | 48 |
| Transmission attenuation, dB | @28 GHz | -46 | -52 | -54 | -53 | -55 | -53 |
| | @77 GHz | -57 | -73 | -74 | -75 | -73 | -72 |

Table 2

| | | Comparative Example 1 | Comparative Example 2 | Comparative Example 3 |
|---|---|---|---|---|
| CNT nonwoven fabric | | Nonwoven fabric #1 | Nonwoven fabric #2 | Nonwoven fabric #3 |
| Protective layer | | Thermosetting resin #1 | Thermosetting resin #1 | Thermosetting resin #1 |
| Resin for laying or impregnation | | - | - | - |
| Embodiment of shielding sheet | | - | - | - |
| Number of CNT nonwoven fabric layers | | 1 | 1 | 1 |
| Total thickness of multilayer film, μm | | 16 | 34 | 91 |
| Transmission attenuation, dB | @28 GHz | -41 | -45 | -55 |
| | @77 GHz | -44 | -53 | -74 |

In Tables 1 and 2, the multilayer film encompasses fabric/resin laminate, prepreg laminate, and prepreg/fabric laminate.

A comparison of Example 1 with Comparative Example 2 and of Examples 2 to 6 with Comparative Example 3 reveals that the EM-shielding sheet having two or more layers of CNT nonwoven fabric with a small thickness exhibits equivalent EM shielding properties to the use of only one layer of CNT nonwoven fabric with a large thickness. This makes it possible to reduce the total thickness of the EM-shielding sheet.

The EM-shielding sheet is easily applicable to electronic parts and connections mounted within electronic equipment for the EM shielding purpose. Electronic equipment complying with high-speed communications of 5G, 6G or later are achievable.

## Claims

1. An electromagnetic-shielding sheet comprising a carbon nanotube nonwoven fabric having a resistivity of 0.00005 to 0.05 Ω·cm and a thickness of 1 to 500 μm and a resin,

    the sheet comprising
    a multilayer film including at least two layers of the carbon nanotube nonwoven fabric and having a total thickness of 5 to 1,500 μm,
    an adhesive layer disposed on one outermost surface of the multilayer film, and
    a release film disposed on the adhesive surface of the adhesive layer.

2. The electromagnetic-shielding sheet of claim 1 wherein the multilayer film is a fabric/resin laminate including the carbon nanotube nonwoven fabric and a resin film disposed one on another.

3. The electromagnetic-shielding sheet of claim 2 wherein the resin film is a film of a thermoplastic resin having a softening point of up to 400°C.

4. The electromagnetic-shielding sheet of claim 3 wherein the thermoplastic resin is at least one resin selected from among polyethylene, polypropylene, fluorochemical resin, polyethylene terephthalate, polyethylene naphthalate, and polyimide.

5. The electromagnetic-shielding sheet of claim 2 wherein the resin film is a film of a thermosetting resin which is at least one resin selected from among an epoxy resin, allylated epoxy resin, allylated polyphenylene ether resin, phenolic resin, polyimide resin, polyamide resin, bismaleimide resin, maleimide resin, cyanate resin, cyclopentadiene-styrene copolymer resin, polyester resin, silicone resin, and acrylic resin.

6. The electromagnetic-shielding sheet of claim 1 wherein the multilayer film is a prepreg laminate composed of at least two layers of carbon nanotube nonwoven fabric impregnated with the resin.

7. The electromagnetic-shielding sheet of claim 1 wherein the multilayer film is a prepreg/fabric laminate including a prepreg film of carbon nanotube nonwoven fabric impregnated with the resin and a carbon nanotube nonwoven fabric layer disposed one on another.

8. The electromagnetic-shielding sheet of claim 6 or 7 wherein the resin contains at least one thermoplastic resin selected from among polyethylene, polypropylene, fluorochemical resin, polyethylene terephthalate, polyethylene naphthalate, and polyimide.

9. The electromagnetic-shielding sheet of claim 6 or 7 wherein the resin contains at least one thermosetting resin selected from among an epoxy resin, allylated epoxy resin, allylated polyphenylene ether resin, phenolic resin, polyimide resin, polyamide resin, bismaleimide resin, maleimide resin, cyanate resin, cyclopentadiene-styrene copolymer resin, polyester resin, silicone resin, and acrylic resin.

10. The electromagnetic-shielding sheet of any one of claims 1 to 9 wherein the carbon nanotube nonwoven fabric is composed of single-walled carbon nanotubes, multi-walled carbon nanotubes or a mixture thereof.

# FIG.1A

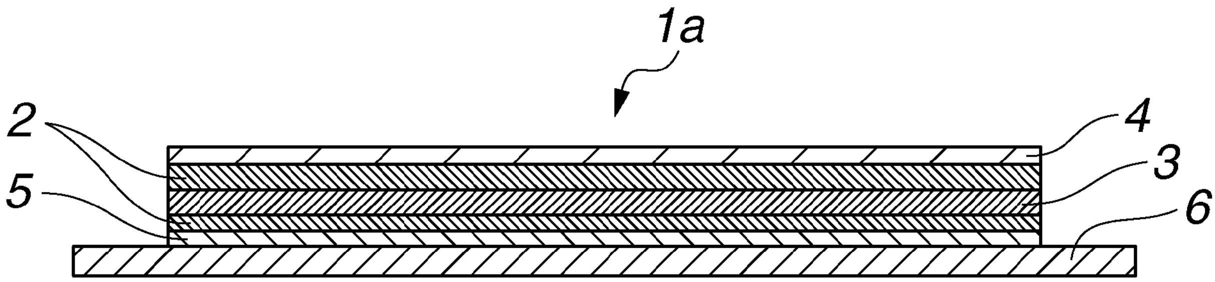


# FIG.1B

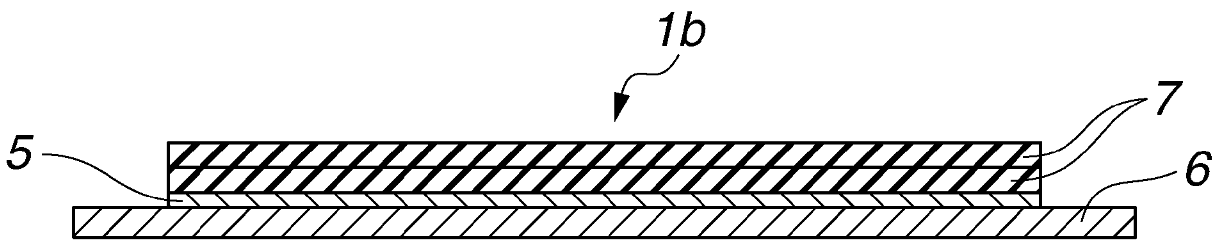


# FIG.1C

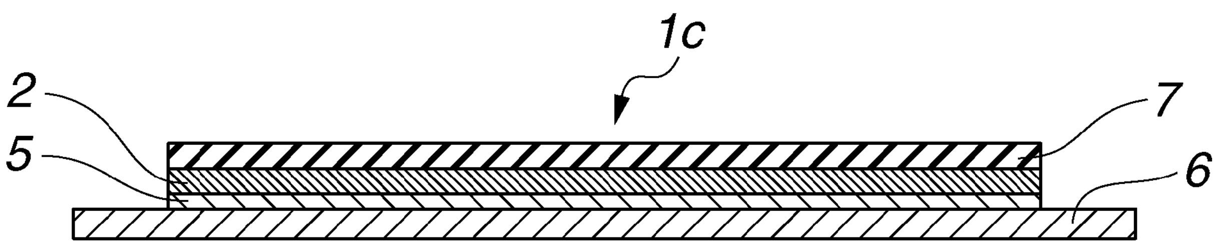

FIG.2

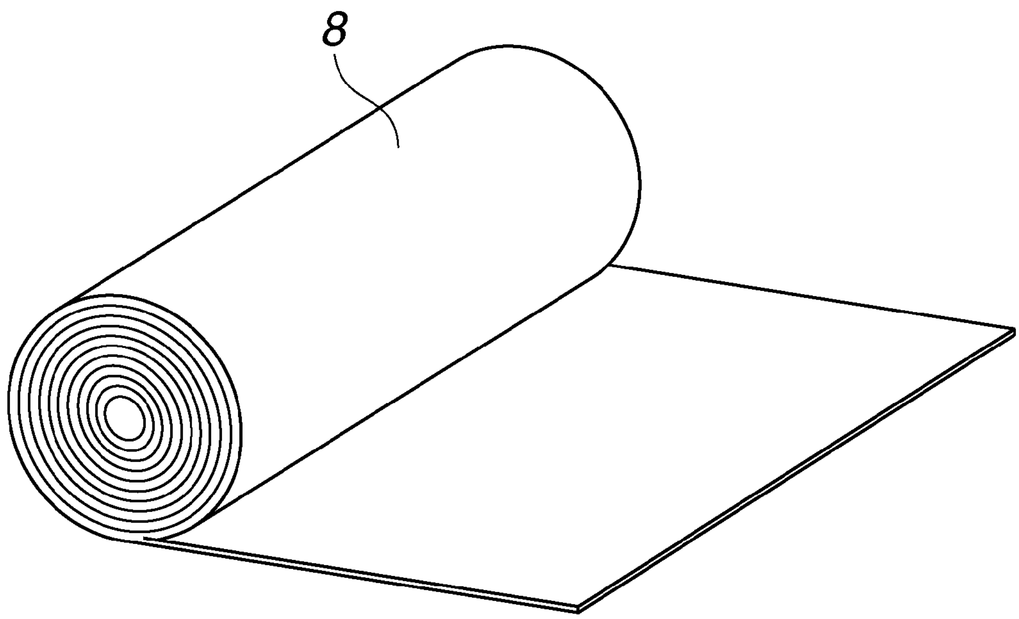

# FIG.3

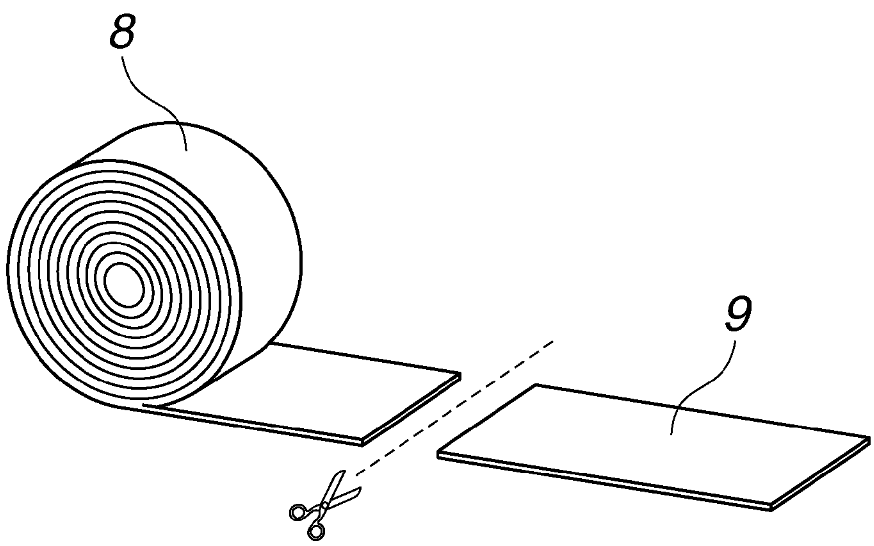

# FIG.4A

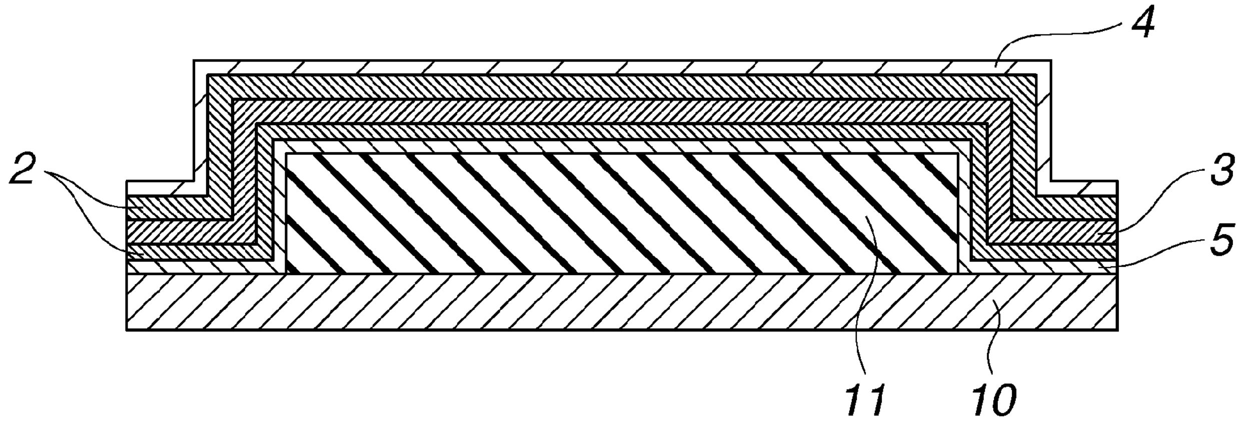


# FIG.4B

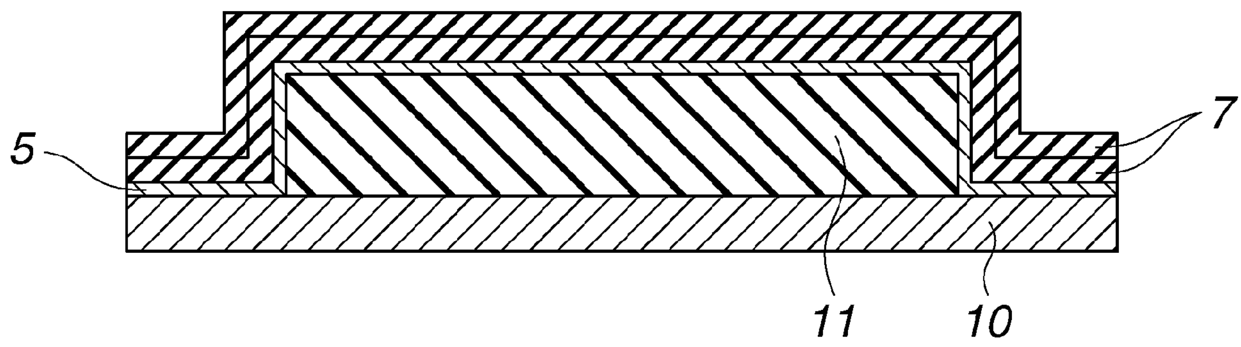


# FIG.4C

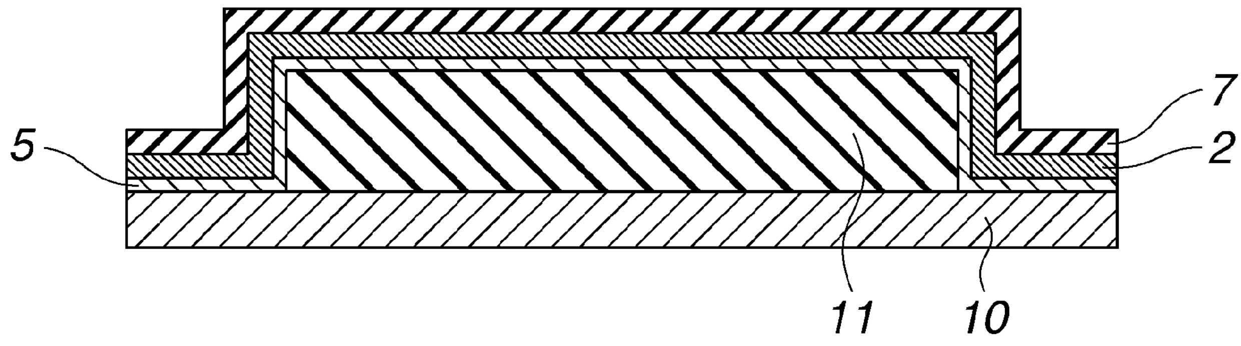

# FIG.5

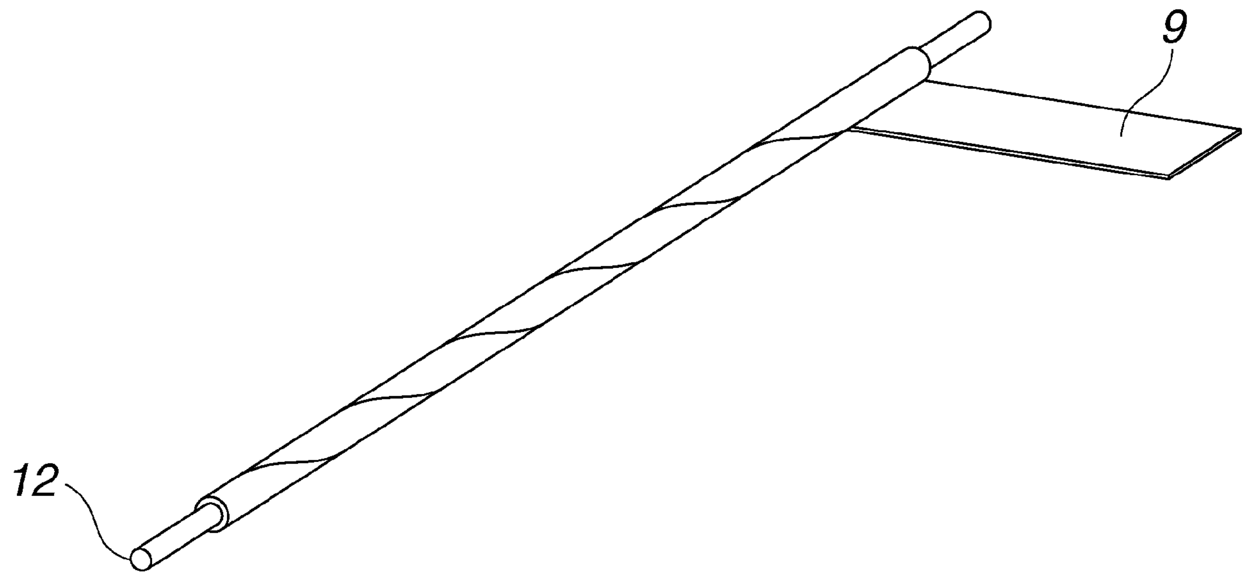

# FIG.6

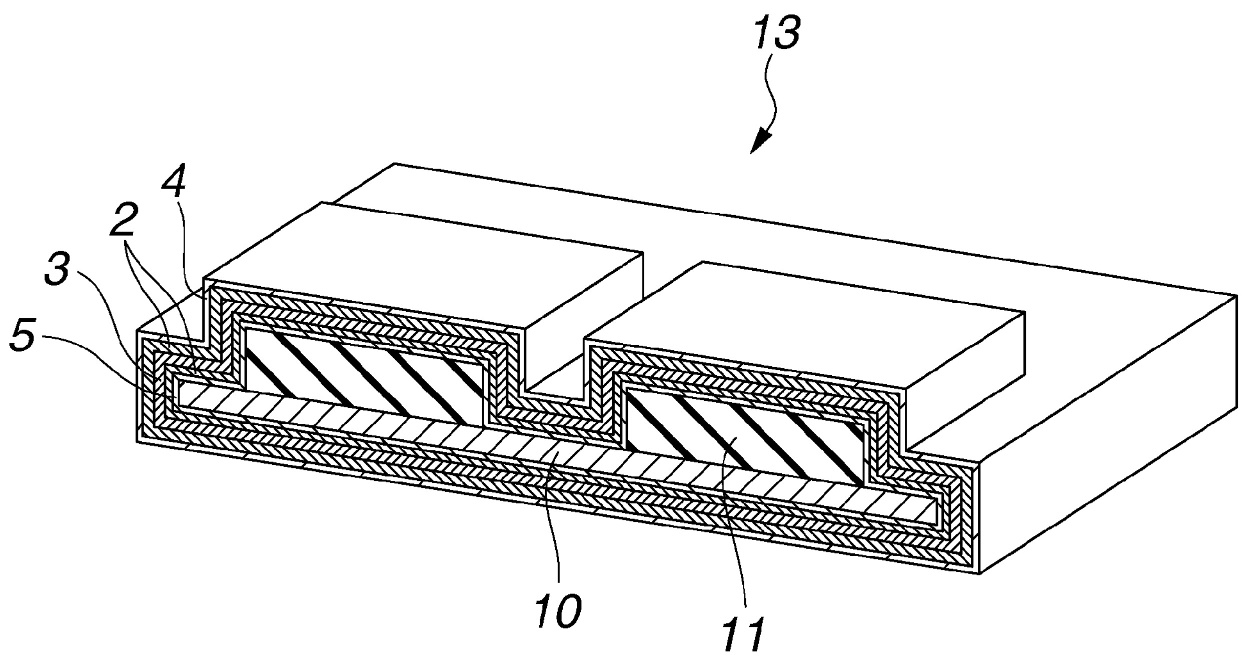

# FIG.7

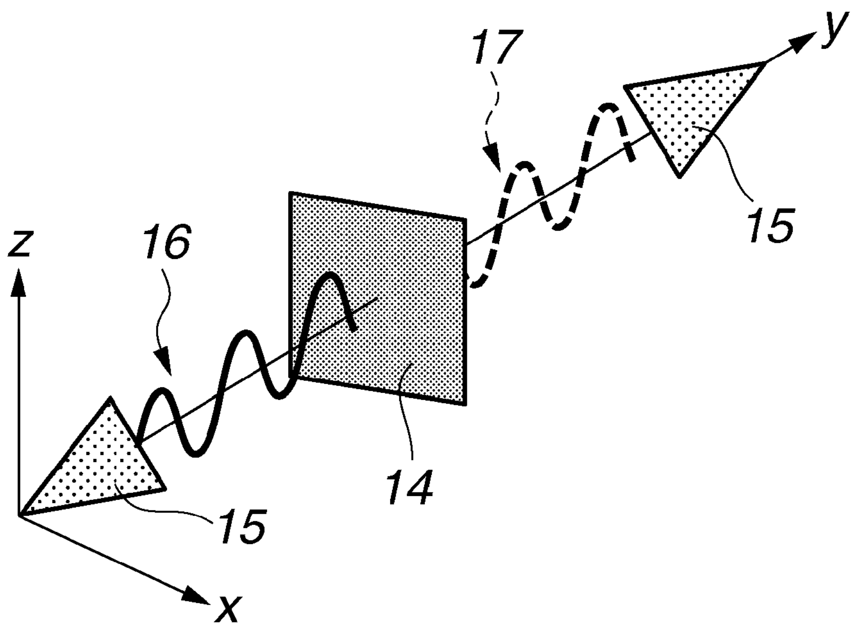

Europäisches Patentamt
European Patent Office
Office européen des brevets

# EUROPEAN SEARCH REPORT

Application Number
EP 25 18 5811

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 118 139 393 A (SHINETSU CHEMICAL CO) 4 June 2024 (2024-06-04) * paragraphs [0035], [0158] - [0183] * * examples 6-8 * * claims 1,2,5,6,9,10 * ----- | 1-10 | INV. B32B5/02 B32B5/26 B32B7/12 B32B27/12 B32B27/28 B32B27/30 B32B27/32 B32B27/36 B32B27/38 B32B27/42 |
| A | JP 2023 182536 A (SHINETSU CHEMICAL CO) 26 December 2023 (2023-12-26) * claims 1,3,5,6 * * paragraph [0065] * ----- | 1-10 | |
| A | KR 101 407 684 B1 (FUJIMORI KOGYO KK) 17 June 2014 (2014-06-17) * claim 8 * ----- | 1-10 | |

TECHNICAL FIELDS SEARCHED (IPC)

B32B

The present search report has been drawn up for all claims

1

| Place of search | Date of completion of the search | Examiner |
|---|---|---|
| The Hague | 5 November 2025 | Yu, Sze Man |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
......................................................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 25 18 5811

This annex lists the patent family members relating to the patent documents cited in the above-mentioned European search report. The members are as contained in the European Patent Office EDP file on
The European Patent Office is in no way liable for these particulars which are merely given for the purpose of information.

05-11-2025

| Patent document cited in search report | Publication date | Patent family member(s) | Publication date |
|---|---|---|---|
| CN 118139393 A | 04-06-2024 | CN 118139393 A | 04-06-2024 |
| | | JP 2024080628 A | 13-06-2024 |
| | | US 2024206139 A1 | 20-06-2024 |
| JP 2023182536 A | 26-12-2023 | JP 2023182536 A | 26-12-2023 |
| | | US 2023399478 A1 | 14-12-2023 |
| KR 101407684 B1 | 17-06-2014 | CN 102762083 A | 31-10-2012 |
| | | CN 105208843 A | 30-12-2015 |
| | | JP 5707216 B2 | 22-04-2015 |
| | | JP 2012231021 A | 22-11-2012 |
| | | KR 20120121357 A | 05-11-2012 |
| | | KR 20140063548 A | 27-05-2014 |
| | | TW 201309111 A | 16-02-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009144000 A
- JP 2012174833 A
- JP 2015187077 A